## Europäisches Patentamt
## European Patent Office
## Office européen des brevets

(19)

(11) Veröffentlichungsnummer: **0 215 289 B1**

(12) **EUROPÄISCHE PATENTSCHRIFT**

(45) Veröffentlichungstag der Patentschrift: **09.10.91**

(51) Int. Cl.5: **H01L 31/20**, H01L 21/31, H01L 31/0376

(21) Anmeldenummer: **86111086.4**

(22) Anmeldetag: **11.08.86**

(54) **Verfahren zur Herstellung einer hochsperrenden Diodenanordnung auf der Basis von a-Si:H für Bildsensorzeilen.**

(30) Priorität: 23.08.85 DE 3530235

(43) Veröffentlichungstag der Anmeldung:
25.03.87 Patentblatt 87/13

(45) Bekanntmachung des Hinweises auf die
Patenterteilung:
09.10.91 Patentblatt 91/41

(84) Benannte Vertragsstaaten:
DE FR GB NL

(56) Entgegenhaltungen:
EP-A- 0 030 162
EP-A- 0 039 219

JOURNAL OF THE ELECTROCHEMICAL SO-
CIETY, Band 132, Nr. 6, Juni 1985, Seiten
1460-1466, Manchester, New Hampshire, US;
S.-I. KIMURA et al.: "Low temperature oxidation of silicon in a microwave-discharged
oxygen plasma"

JAPANESE JOURNAL OF APPLIED PHYSICS,
"Supplements", Band 22, Nr. 22-1, 1983, Seiten 461-464, Tokyo, JP; S. ISHIOKA et al.:

"Single-tube color imager using hydrogenated amorphous silicon"

INTERNATIONAL ELECTRON DEVICES MEE-
TING, San Francisco, US, 13.-15. Dezember,
Seiten 328-331, IEEE, New York, US; S. KANE-
KO et al.: "Amorphous SI:H contact linear
image sensor with SI3N4 blocking layer"

(73) Patentinhaber: SIEMENS AKTIENGESELL-
SCHAFT
Wittelsbacherplatz 2
W-8000 München 2(DE)

(72) Erfinder: Hoheisel, Martin, Dr.
Görzer Strasse 97
W-8000 München 90(DE)
Erfinder: Brunst, Gerhard, Dr.
Hörwarthstrasse 25
W-8000 München 40(DE)
Erfinder: Holzenkämpfer, Enno, Dr.
Bunsenstrasse 9
W-8000 München 83(DE)

## Beschreibung

Die Erfindung betrifft ein Herstellverfahren für eine hochsperrende Diodenanordnung für Bildsensoren mit einem Halbleiterkörper aus amorphem, wasserstoffhaltigem Silizium (a-Si:H), mit einer, die Injektion von Ladungsträgern blockierenden Schicht, mit zwei leitenden Elektroden und einem Substrat aus elektrisch isolierendem Material, wobei der Halbleiterkörper als Dünnschicht zwischen den zwei leitenden Elektroden auf dem Substrat angeordnet ist und auf dem Halbleiterkörper auf der dem Substrat abgewandten Seite die Blockierschicht angeordnet ist, die durch Umwandlung der a-Si:H-Oberfläche in Siliziumoxid erzeugt wird.

Die Herstellung und der Aufbau großflächiger, preisgünstiger Bildsensoren mittels der Dünnfilmtechnik von a-Si:H zwischen zwei Elektroden wird beispielsweise in einem Bericht von E. Holzenkämpfer, K. Rosan und K. Kempter in den Proc. of the MRS Europe, Strasbourg, (1984) auf den Seiten 575 bis 579 beschrieben.

Die Anforderungen, die an Bildsensorzeilen gestellt werden, sind neben einer hohen Fotoempfindlichkeit vor allem ein niedriger Dunkelstrom, eine große Homogenität der Elemente in einer Zeile in bezug auf Strom-Spannungskennlinien und eine große Stabilität auch nach längerer Beleuchtung. Ursachen für das Auftreten von Störungen in dieser Richtung sind unter anderem Vorgänge, die sich an den Kontaktgrenzflächen abspielen.

Aus dem Stand der Technik ist aus einem Aufsatz von S. Kaneko et. al. aus dem Journal of Non-Crystalline Solids 59/60 (1983), Seiten 1227 bis 1230, eine hochsperrende Diodenanordnung auf der Basis von A-Si:H für die Anwendung in Sensorzeilen bekannt, bei der zwischen der transparenten Indium-Zinnoxid-Elektrode und dem aus amorphem SiH bestehenden Halbleiterkörper eine Blockierschicht aus Siliziumnitrid vorhanden ist. Der a-Si:H Körper besteht dabei aus einer Doppelschicht aus i a-Si:H (2,5 $\mu$m) und p a-Si:H (200 nm). Die Blockierschicht aus Siliziumnitrid befindet sich auf der dem Glassubstrat zugewandten Seite des Halbleiterkörpers (i a-Si:H), von der aus der Lichteinfall erfolgt. Die Herstellung der bekannten Anordnung erfordert einen hohen technischen Aufwand, bedingt durch die Abscheidung mehrerer Schichten mit der Gefahr der Dotierungsverschleppung beim Niederschlag der bordotierten $p^+$-Zwischenschicht aus amorphem Silizium.

Eine weitere Möglichkeit der Verbesserungen der Sperreigenschaften von Sensorelementen auf der Basis von a-Si:H als Fotoleiter ist aus einem Bericht von H. Yamamoto et. al. aus den Extended Abstracts of the 15th Conference on Solid State Devices and Materials, Tokyo, 1983, Seiten 205 bis 208, bekannt. Dabei enthält die Diodenanordnung neben der Fotodiode anstelle einer Blockierschicht eine integrierte Blockierdiode. Auch dieser Aufbau erfordert mehrere umständliche und zeitaufwendige Prozeßschritte, da neben der a-Si:H-Schicht auch $p^+$-und $n^+$-a-Si:H-Schichten verwendet werden, die in verschiedenen Reaktoren erzeugt werden müssen. Ansonsten besteht auch hier, wie bei der Kaneko-Anordnung, die Gefahr der Dotierungsverschleppung.

Aus der europäischen Patentanmeldung EP-A-0 039 219 ist ein lichtempfindlicher Film bekannt, der unter anderem ein lichtdurchlässiges Substrat, einen durchsichtigen leitfähigen Film und einen photoleitenden Film enthält.

Der photoleitende Film besteht aus amorphem Silizium. Zwischen dem durchsichtigen leitenden Film und dem photoleitenden Film ist eine Blockierschicht vorgesehen. Die Blockierschicht ist auf der dem Substrat zugewandten Seite des photoleitenden Films angeordnet. Sie muß hier in einem separaten Schritt durch Sputtern erzeugt werden.

Aus der europäischen Patentanmeldung EP-A-0 030 162 ist ein Verfahren zur Herstellung eines dünnen Siliziumoxidfilms auf photoleitendem amorphem Silizium bekannt. Dabei wird die Oberfläche des amorphen Siliziums zunächst geätzt und dann mit einem Oxidationsmittel auf der Basis von Schwefel in Kontakt gebracht. Das Wachstum der Siliziumoxidfilmdicke wird durch die Konzentration, die Temperatur und die Zeit, die das amorphe Silizium einer schwefelsäuren Lösungen ausgesetzt wird, bestimmt.

Es ist Aufgabe der Erfindung, ein einfaches und zuverlässiges Herstellverfahren für eine Diodenanordnung anzugeben, bei der das Sperrverhalten von Kontakten auf a-Si:H, insbesondere bei transparenten Kontakten, die aus leitfähigen Oxiden, dünnen Metallschichten oder Siliziden bestehen, verbessert ist.

Die gestellte Aufgabe wird erfindungsgemäß durch ein Herstellverfahren nach dem Oberbegriff des Anspruchs 1 gelöst, wie dies im kennzeichnenden Teil des Anspruchs 1 angegeben ist.

Im Rahmen der Erfindung soll es nun liegen, daß die Siliziumoxid-Blockierschicht durch Oxidation, vorzugsweise durch Temperung in Sauerstoff oder Luft, oder durch Einwirkung eines Sauerstoffplasmas auf die a-Si:H-Oberfläche erzeugt wird.

Die vorliegende Erfindung schafft somit die Möglichkeit, auf einfachste Weise großflächige Sensorzeilen herzustellen, die in bezug auf elektrischen Eigenschaften, wie Sperrströme und Spannungsfestigkeit, den heutigen Anforderungen genügen. Die entstandene Siliziumoxidschicht führt außerdem zu einer Verbesserung der chemischen Stabilität der Grenzfläche zwischen a-Si und dem leitfähigen Oxid der transparenten Elektrode. Dies ermöglicht eine reproduzierbare Herstellung von Sensorzeilen.

Weitere Ausgestaltungen der Erfindung ergeben sich aus den Unteransprüchen.

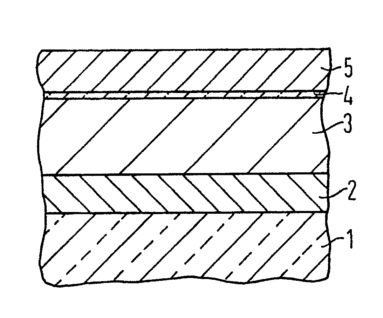

Die Erfindung wird im folgenden anhand der Figur, die im Schnittbild den Schichtaufbau eines Einzelsensors zeigt, noch näher erläutert.

Es gelten folgende Bezugszeichen:

1 = Substratkörper, zum Beispiel aus Glas,

2 = metallische Grundelektrode, zum Beispiel aus Titan, 300 nm,

3 = a-Si:H-Schicht undotiert, ca. 1000 nm dick,

4 = erfindungsgemäße SiO₂-Blockierschicht, 1 nm dick,

5 = transparente Oberflächenelektrode, zum Beispiel aus ITO (= Indiumzinnoxid), 100 nm dick, Palladiumsilizid oder Palladium, 10 nm dick, welche die zu beleuchtende Seite der Anordnung kennzeichnet.

Die Bildung der erfindungsgemäßen SiO₂-Blokkierschicht (4) kann auf verschiedene Weise erfolgen:

1. durch Temperung in Sauerstoff bei 200°C, 1000 mbar Druck, 30 Minuten,

2. langsame Oxidation an Luft, Zimmertemperatur, 1000 mbar Druck, ca. 14 Tage,

3. Plasmaätzung in Sauerstoff bei 35°C Substrattemperatur, 0,4 mbar Druck, 10 Minuten (Fluß 100 sccm, Leistung 0,5 W/cm²),

4. Veraschung des bei der Strukturierung der Elektroden verwendeten Fotolackes im Sauerstoffplasma bei 35°C Substrattemperatur, 0,5 mbar Druck, 10 Minuten (Fluß 100 sccm, Leistung 0,7 W/cm²).

Folgende Resultate wurden erzielt:

I. Spannungsfestigkeit

a) ohne SiO₂-Blockierschicht; bei 50 Volt sind alle Zellen defekt;

b) mit SiO₂-Blockierschicht; bei 50 Volt sind zwei Drittel der Zellen funktionsfähig.

II.

1. Sperrstrom (bei 4 V) mit ITO-Elektrode

a) ohne SiO₂-Blockierschicht 3 × 10⁻⁷ A/cm²,

b) mit SiO₂-Blockierschicht 5 × 10⁻⁸ A/cm²,

2. Sperrstrom (bei 4 V) mit Palladium-Elektroden

a) ohne SiO₂-Blockierschicht 2 × 10⁻⁹ A/cm²,

b) mit SiO₂-Blockierschicht 4 × 10⁻¹⁰ A/cm².

**Patentansprüche**

1. Herstellverfahren für eine hochsperrende Diodenanordnung für Bildsensoren mit einem Halbleiterkörper aus amorphem, wasserstoffhaltigem Silizium (a-Si:H), mit einer die Injektion von Ladungsträgern blockierenden Schicht, mit zwei leitenden Elektroden und einem Substrat aus elektrisch isolierendem Material, wobei der Halbleiterkörper als Dünnschicht zwischen den zwei leitenden Elektroden auf dem Substrat angeordnet ist und auf dem Halbleiterkörper auf der dem Substrat abgewandten Seite die Blockierschicht angeordnet ist, die durch Umwandlung der a-Si:H-Oberfläche in Siliziumoxid erzeugt wird, **dadurch gekennzeichnet,** daß die die Injektion von Ladungsträgern verhindernde Siliziumoxid-Blockierschicht (4) durch Oxidation unter Einwirkung von Sauerstoff oder Luft oder eines Sauerstoffplasmas erzeugt wird.

2. Herstellverfahren nach Anspruch 1, **dadurch gekennzeichnet,** daß die Siliziumoxid-Blokkierschicht (4) durch Temperung in Sauerstoff oder Luft erzeugt wird.

3. Herstellverfahren nach einem der Ansprüche 1 oder 2, **dadurch gekennzeichnet,** daß die Siliziumoxid-Blockierschicht (4) in einer Dicke zwischen 0,5 und 10 nm erzeugt wird.

4. Herstellverfahren nach einem der Ansprüche 1 bis 3, **dadurch gekennzeichnet,** daß auf dem Substrat (1) aus elektrisch isolierendem Material eine Metallschicht (2) als Grundelektrode erzeugt wird, daß auf die Metallschicht (2) eine undotierte a-Si:H-Schicht (3) als Halbleiterkörper abgeschieden wird, daß die Oberfläche der undotierten a-Si:H-Schicht (3) in eine Siliziumoxidschicht (4) als Blockierschicht umgewandelt wird und daß auf der Siliziumoxidschicht (4) eine transparente Elektrode (5) erzeugt wird.

5. Herstellverfahren nach Anspruch 4, **dadurch gekennzeichnet,** daß auf dem Substrat (1) aus Glas eine 300 nm dicke Titanschicht (2) als Grundelektrode erzeugt wird, daß auf der Titanschicht (2) eine undotierte a-Si:H-Schicht (3) als Halbleiterkörper in einer Dicke von 1000 nm abgeschieden wird, daß die Oberfläche der undotierten a-Si:H-Schicht (3) in einer 1 nm dicke Siliziumoxidschicht (4) als Blockierschicht umgewandelt wird und daß auf der Siliziumoxidschicht (4) eine 100 nm dicke Indium-Zinn-Oxidschicht oder eine 10 nm dikke Palladiumsilizid- oder Palladiumschicht (5) als transparente Elektrode erzeugt wird.

**Claims**

1. Method of manufacturing a highly blocking diode structure for image sensors, which diode structure has a semiconductor body of amorphous, hydrogen-containing silicon (a-Si:H), a layer blocking the injection of charge carriers, two conductive electrodes and a substrate of electrically insulating material, the semiconductor body being arranged on the substrate as a thin film between the two conductive electrodes, and the blocking layer, which is generated by converting the a-Si:H surface into silicon oxide, being arranged on the semiconductor body on the side averted from the substrate, characterised in that the silicon oxide blocking layer (4) preventing the injection of charge carriers is generated by oxidation under the influence of oxygen or air or an oxygen plasma.

2. Method of manufacturing according to Claim 1, characterised in that the silicon oxide blocking layer (4) is generated by annealing in oxygen or air.

3. Method of manufacturing according to one of Claims 1 or 2, characterised in that the silicon oxide blocking layer (4) is generated at a thickness between 0.5 and 10 nm.

4. Method of manufacturing according to one of Claims 1 to 3, characterised in that a metal layer (2) is generated as base electrode on the substrate (1) of electrically insulating material, in that an undoped a-Si:H layer (3) is deposited as the semiconductor body onto the metal layer (2), in that the surface of the undoped a-Si:H layer (3) is converted into a silicon oxide layer (4) as blocking layer, and in that a transparent electrode (5) is generated on the silicon oxide layer (4).

5. Method of manufacturing according to Claim 4, characterised in that a 300 nm thick titanium layer (2) is generated as base electrode on the substrate (1) of glass, in that an undoped a-Si:H layer (3) is deposited as the semiconductor body at a thickness of 1000 nm on the titanium layer (2), in that the surface of the undoped a-Si:H layer (3) is converted in a 1 nm thick silicon oxide layer (4) as the blocking layer, and in that a 100 nm thick indium/tin oxide layer or a 10 nm thick palladium silicide layer or palladium layer (5) is generated as the transparent electrode on the silicon oxide layer (4).

**Revendications**

1. Procédé pour fabriquer une structure de diode réalisant un blocage intense pour des détecteurs d'images, comportant un corps semiconducteur formé d'un silicium amorphe contenant de l'hydrogène (a-Si:H), une couche bloquant l'injection de porteurs de charge, deux électrodes conductrices et un substrat réalisé en un matériau électriquement isolant, le corps semiconducteur étant disposé sous la forme d'une couche mince entre les deux électrodes conductrices sur le substrat, tandis que sur le corps semiconducteur est disposée, sur la face tournée à l'opposé du substrat, la couche de blocage qui est produite par transformation de la surface du a-Si:H en oxyde de silicium, caractérisé par le fait que la couche de blocage (4) formée d'oxyde de silicium, qui empêche l'injection de porteurs de charge, est formée par oxydation sous l'action de l'oxygène ou de l'air ou d'un plasma d'oxygène.

2. Procédé de fabrication suivant la revendication 1, caractérisé par le fait que la couche de blocage (4) formée d'oxyde de silicium est formée par recuit dans de l'oxygène ou dans de l'air.

3. Procédé de fabrication suivant l'une des revendications 1 ou 2, caractérisé par le fait que la couche de blocage (4) formée d'oxyde de silicium est formée avec une épaisseur comprise entre 0,5 et 10 nm.

4. Procédé de fabrication suivant l'une des revendications 1 à 3, caractérisé par le fait qu'on forme en tant qu'électrode de base une couche métallique (2) sur le substrat (1) réalisé en un matériau électriquement isolant, qu'on dépose une couche de a-Si:H non dopé (3) en tant que corps semiconducteur sur la couche métallique (2), qu'on transforme la surface de la couche de a-Si:H non dopé (3) en une couche d'oxyde de silicium (4) formant couche de blocage et qu'on forme sur la couche d'oxyde de silicium (4) une électrode transparente (5).

5. Procédé de fabrication suivant la revendication 4, caractérisé par le fait qu'on forme en tant qu'électrode de base une couche de titane (2) possédant une épaisseur de 300 nm sur le substrat (1) en verre, qu'on dépose en tant que corps semiconducteur, sur une épaisseur de 1000 nm, une couche de a-Si:H non dopé (3) sur la couche de titane (2), qu'on transforme la surface de la couche de a-Si:H non dopé (3) en une couche d'oxyde de silicium (4) possédant une épaisseur de 1 nm, en tant que couche de blocage, et qu'on forme sur la couche d'oxyde de silicium (4), une couche d'oxyde d'indium et d'étain possédant une épaisseur de 100 nm ou une couche de siliciure de palladium ou de palladium (5) possédant une épaisseur de 10 nm en tant qu'électrode transparente.